(19) Europäisches Patentamt
European Patent Office
Office européen des brevets

(11) Veröffentlichungsnummer: **0 027 506**
**B1**

(12) **EUROPÄISCHE PATENTSCHRIFT**

(45) Veröffentlichungstag der Patentschrift: **11.05.83**

(51) Int. Cl.³: **G 03 C 1/70**, G 02 B 5/14

(21) Anmeldenummer: **80104637.6**

(22) Anmeldetag: **06.08.80**

(54) **Polyimid-, Polyisoindolochinazolindion-, Polyoxazindion- und Polychinazolindion-Vorstufen, deren Herstellung und Verwendung.**

(30) Priorität: **21.08.79 DE 2933826**

(43) Veröffentlichungstag der Anmeldung: **29.04.81 Patentblatt 81/17**

(45) Bekanntmachung des Hinweises auf die Patenterteilung: **11.05.83 Patentblatt 83/19**

(84) Benannte Vertragsstaaten: **AT BE CH DE FR GB IT LI NL SE**

(56) Entgegenhaltungen: **Keine**

(73) Patentinhaber: **SIEMENS AKTIENGESELLSCHAFT**
**Berlin und München Wittelsbacherplatz 2**
**D-8000 München 2 (DE)**

(72) Erfinder: **Ahne, Hellmut, Dr.**
**Heidestrasse 6**
**D-8551 Röttenbach (DE)**
Erfinder: **Kühn, Eberhard**
**Bergstrasse 32**
**D-8551 Hemhofen (DE)**
Erfinder: **Rubner, Roland, Dr.**
**Buchenring 15**
**D-8551 Röttenbach (DE)**

**EP 0 027 506 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

# Polyimid-, Polyisoindolochinazolindion-, Polyoxazindion- und Polychinazolindion-Vorstufen, deren Herstellung und Verwendung

Die Erfindung betrifft oligomere und/oder polymere strahlungsreaktive Vorstufen von Polyimiden, Polyisoindolochinazolindionen, Polyoxazindionen und Polychinazolindionen sowie ein Verfahren zur Herstellung dieser strahlungsreaktiven Vorstufen.

Vorstufen der genannten Art, die in organischen Lösungsmitteln löslich sind, sind beispielsweise aus der deutschen Patentschrift 2 308 830 bzw. der entsprechenden US-Patentschrift 3 957 512 bekannt. Die bekannten polymeren Vorstufen sind Polyadditions- oder Polykondensationsprodukte polyfunktioneller carbocyclischer oder heterocyclischer, strahlungsempfindliche Reste tragender Verbindungen mit Diaminen, Diisocyanaten, Bis-säurechloriden oder Dicarbonsäuren. Die strahlungsempfindliche Reste tragenden Verbindungen enthalten zwei für Additions- oder Kondensationsreaktionen geeignete Carboxyl-, Carbonsäurechlorid-, Amino-, Isocyanat- oder Hydroxylgruppen und teilweise in ortho- oder peri-Stellung dazu esterartig an Carboxylgruppen gebundene strahlungsreaktive Gruppen und die mit diesen Verbindungen umzusetzenden Diamine, Diisocyanate, Bis-säurechloride und Dicarbonsäuren weisen mindestens ein cyclisches Strukturelement auf.

Strahlungsreaktive Polyimid-Vorstufen werden dabei insbesondere in der Weise hergestellt, daß ungesättigte Alkohole, wie Allylalkohol, an Tetracarbonsäuredianhydride, wie Pyromellithsäuredianhydrid, addiert, die freien Carbonsäuregruppen der dabei gebildeten Diester in Säurechloridgruppen übergeführt und die entstandenen Diester-bis-säurechloride einer Polykondensationsreaktion mit einem — meist aromatischen — Diamin, wie Diaminodiphenyläther, unterworfen werden. Bei der Verwendung von Diaminoverbindungen, die ortho-ständige Amidogruppen aufweisen, entstehen in entsprechender Weise Polyisoindolochinazolindione.

Polyoxazindion-Vorstufen entstehen durch Polyaddition von Diisocyanaten, wie Diphenylmethandiisocyanat, an phenolische Hydroxylgruppen olefinisch ungesättigter Diester, wie Methylen-disalicysäureester, und — in entsprechender Weise — Polychinazolindione durch Polyaddition von Diisocyanaten an Aminogruppen olefinisch ungesättigter Diester.

Die bekannten Herstellungsverfahren erfordern im allgemeinen mehrere Reaktionsschritte und auch tiefe Temperaturen. Darüber hinaus ist einerseits bei der Verwendung von Säurechloriden eine intensive Reinigung der Reaktionsprodukte erforderlich, andererseits ist die Synthese von ungesättigten Diestern der genannten Art schwierig durchzuführen.

Aufgabe der Erfindung ist es, oligomere und/oder polymere Vorstufen von Polyimiden, Polyisoindolochinazolindionen, Polyoxazindionen und Polychinazolindionen bereitzustellen, die in organischen Lösungsmitteln löslich, strahlungsreaktiv und in einfacher Weise herstellbar sind.

Dies wird erfindungsgemäß dadurch erreicht, daß die Vorstufen aus Additionsprodukten von olefinisch ungesättigten Monoepoxiden an carboxylgruppenhaltige Polyadditionsprodukte aus aromatischen und/oder heterocyclischen Tetracarbonsäuredianhydriden und Diaminoverbindungen, Welchletztere wenigstens eine ortho-ständige Amidogruppe enthalten können, bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten bestehen.

Unter «Tetracarbonsäuredianhydrid» werden im Rahmen der vorliegenden Patentanmeldung Verbindungen verstanden, die wenigstens zwei Säureanhydridgruppierungen aufweisen. Der Begriff «Diaminoverbindungen» soll auch Verbindungen umfassen, die das Strukturelement $>N-N<$ enthalten, d. h. Abkömmlinge des Hydrazins. Unter «Diaminoverbindungen mit wenigstens einer ortho-ständigen Amidogruppe» werden Verbindungen verstanden, die wenigstens eine zu einer der beiden Aminogruppen der Diaminoverbindung ortho-ständige Amidogruppe tragen.

Die erfindungsgemäßen Polyimid-, Polyisoindolochinazolindion-, Polyoxazindion- und Polychinazolindion-Vorstufen können auf einfachem Weg synthetisiert werden. Sie sind strahlungsempfindlich und können somit leicht vernetzt werden; die vernetzten Produkte können dann durch thermische Behandlung in einfacher Weise in hochwärmebeständige Polyimide, Polyisoindolochinazolindione, Polyoxazindione bzw. Polychinazolindione übergeführt werden. Diese Polymer-Vorstufen sind ferner in organischen Lösungsmitteln, insbesondere in polaren Lösungsmitteln, gut löslich. Aus wirtschaftlicher und ökologischer Sicht ist darüber hinaus wesentlich, daß die Vorstufen — aufgrund des Vorhandenseins von Hydroxylgruppen — zumindest teilweise in bzw. aus partiell wäßriger Lösung verarbeitet werden können.

Die erfindungsgemäßen Polymer-Vorstufen eignen sich insbesondere zur Herstellung von strukturierten hochwärmebeständigen Schutz- und Isolierschichten in der Mikroelektronik (Feinstrukturerzeugung) sowie zur Verwendung als Photoresist (vgl. dazu die gleichzeitig eingereichte europäische Patentanmeldung «Verfahren zur Herstellung hochwärmebeständiger Reliefstrukturen und deren Verwendung», EP-A1-0 026 820).

Die erfindungsgemäßen strahlungsreaktiven Vorstufen weisen im allgemeinen folgende Struktur auf:

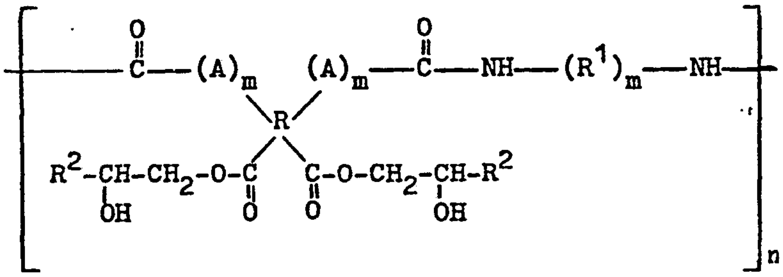

(1)

bzw.

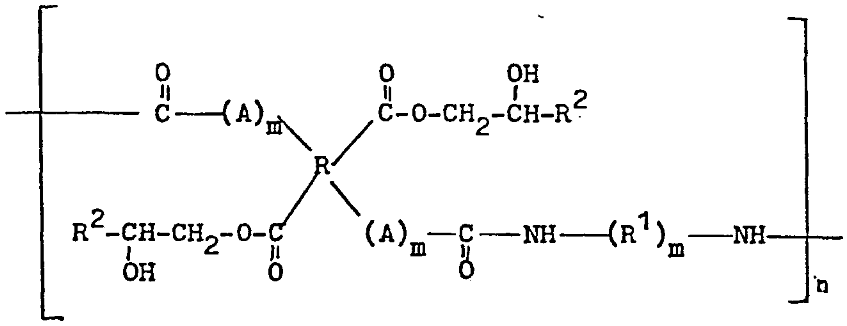

(2)

In den Formeln (1) und (2) bedeutet n eine ganze Zahl von 2 bis etwa 100 und m ist 0 oder 1.

Für R, $R^1$, $R^2$ und A gilt folgendes :

R ist ein — gegebenenfalls halogenierter — zumindest partiell aromatischer und/oder heterocyclischer tetravalenter, d. h. tetrafunktioneller Rest, bei dem jeweils zwei Valenzen in Nachbarstellung zueinander angeordnet sind ; weist der Rest R mehrere aromatische und/oder heterocyclische Strukturelemente auf, so befinden sich die Valenzpaare jeweils an endständigen derartigen Strukturelementen ;

$R^1$ ist ein — gegebenenfalls halogenierter — divalenter, d. h. difunktioneller Rest aliphatischer und/oder cycloaliphatischer, gegebenenfalls Heteroatome aufweisender, und/oder aromatischer und/oder heterocyclischer Struktur ;

$R^2$ ist ein olefinisch ungesättigter Rest, insbesondere eine — gegebenenfalls substituierte — (meth) acrylesterhaltige Gruppe ;

A bedeutet —O— oder —NH—.

Die Reste R, $R^1$ und $R^2$ haben insbesondere folgende Bedeutung :

R = 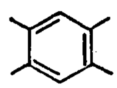 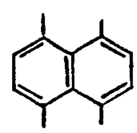, 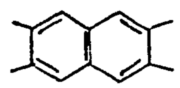, 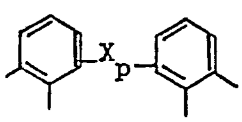,

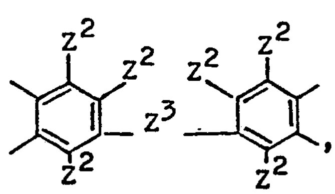, 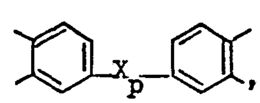, 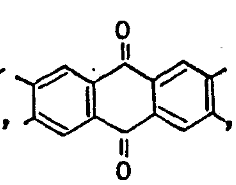,

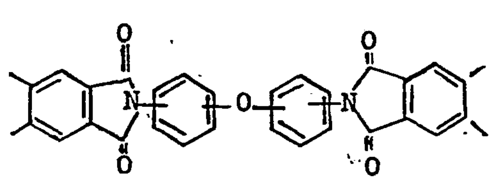, 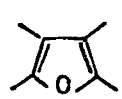 und 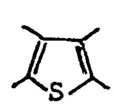,

wobei p = 0 oder 1 ist und X für einen der folgenden Reste steht.

X = 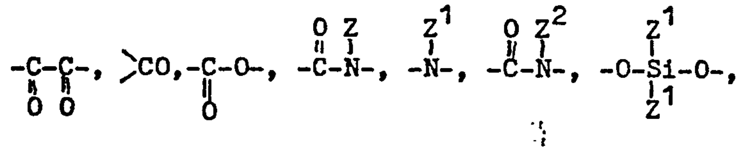

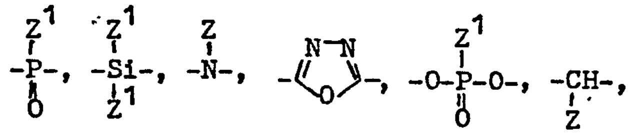

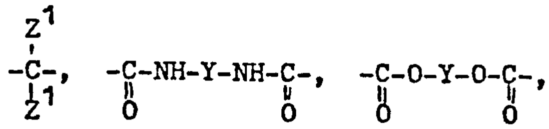 -SO-, $-SO_2-$,

$-SO_2NH-$, -S-, 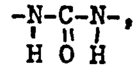, -N=N-,

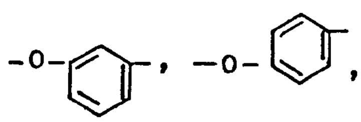, 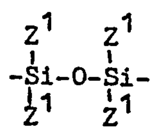 und 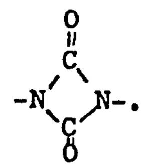.

Für die weiteren Reste gilt :

Y = 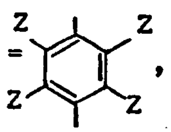, $-(CH_2)_o-$ mit o = 2 bis 10, und

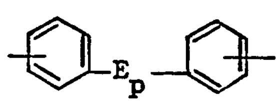 mit p = 0 oder 1,

Z = H oder Alkyl mit 1 bis 6 Kohlenstoffatomen,
$Z^1$ = Alkyl mit 1 bis 10 Kohlenstoffatomen oder Aryl,
$Z^2$ = Aryl oder Heteroaryl, und
$Z^3$ =

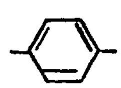 oder 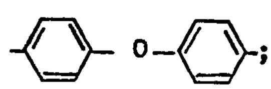;

E = 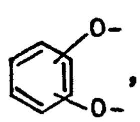, 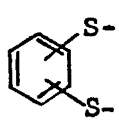, 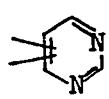, 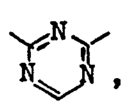, 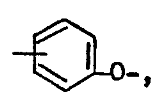,

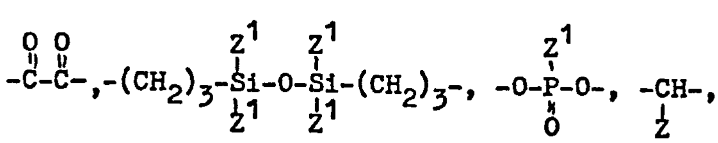

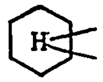 , $-(CH_2)_q-$ , $-(CH_2)_r-$ , $-SO-$, $-SO_2-$,

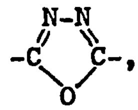, $-SO_2NH-$, 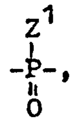, 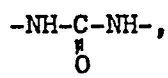, 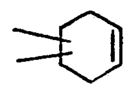,

$-N{=}N-$, 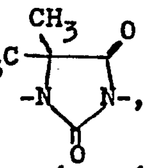, $-S-$, $-O-$, 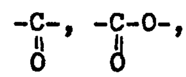

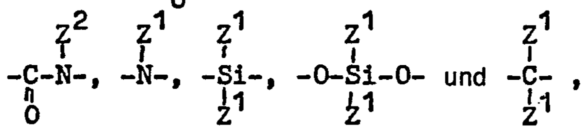

wobei q = 2 bis 14 und r = 2 bis 18, und $Z^1$ und $Z^2$ wie vorstehend definiert sind.

$R^1$ = 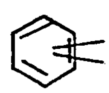, 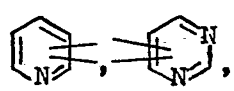, 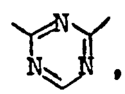,

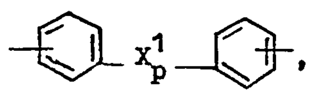, 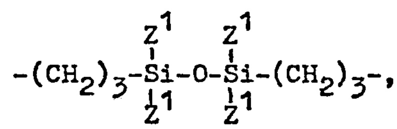

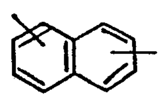, 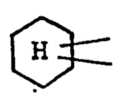, $-(CH_2)_q-$, $-(CF_2)_r-$,

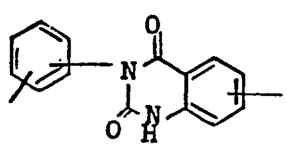, 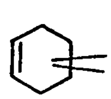, 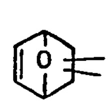, 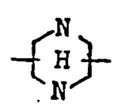,

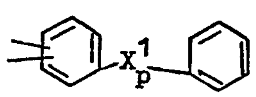, 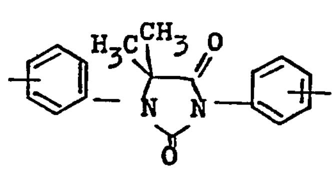

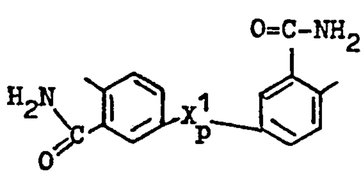 und 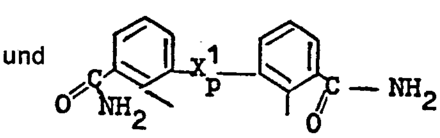,

wobei p = 0 oder 1, q = 2 bis 14 und r = 2 bis 18, und $Z^1$ wie vorstehend definiert ist ;

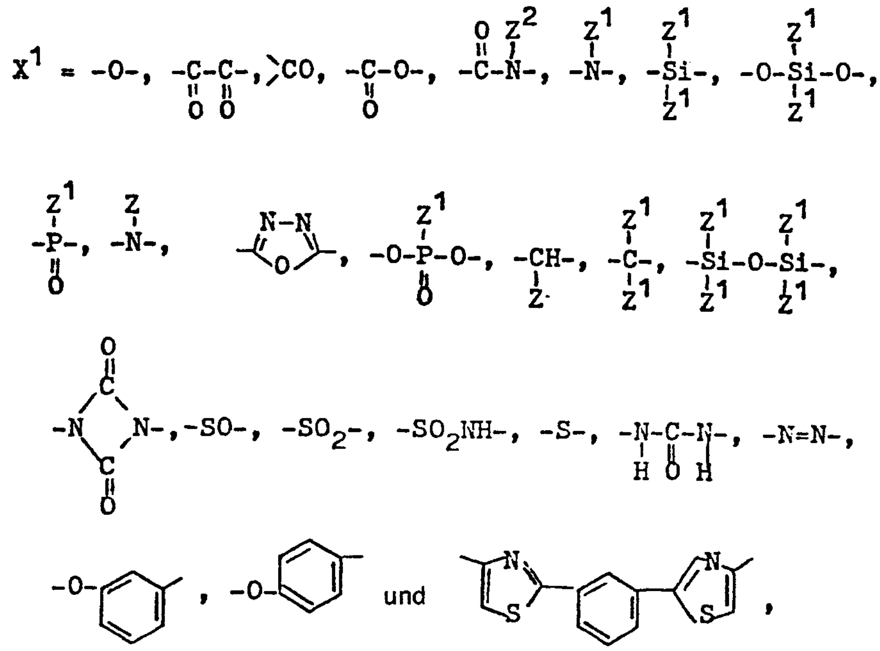

und ,

wobei Z, $Z^1$ und $Z^2$ wie vorstehend definiert sind.

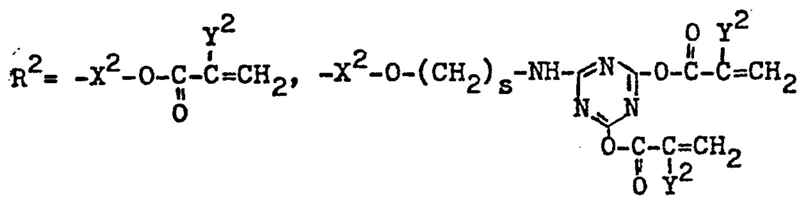

und $—X^2—O—CH_2—CH = CH_2$ ;
dabei ist s = 2 bis 16 ;
für die weiteren Reste gilt :
$X^2 = —CH_2—$ und $—CH_2—O—[(CH_2)_r—O]_t—(CH_2)_s—$, und
$Y^2 = —H, —CH_3, —Cl, —Br$ oder $—C \equiv N$,
wobei r = 2 bis 18, s = 2 bis 16 und t = 1 bis 10.

Die erfindungsgemäßen strahlungsreaktiven Vorstufen sind Additionsprodukte von olefinisch ungesättigten Monoepoxiden an carboxylgruppenhaltige Prepolymere. Diese Prepolymere sind :

— Polyadditionsprodukte von Tetracarbonsäuredianhydriden und Diaminoverbindungen (Polyimid-Prepolymere) ;

— Polyadditionsprodukte von Tetracarbonsäuredianhydriden und o-Aminoamiden (Polyisoindolochinazolindion-Prepolymere) ;

— Polyadditionsprodukte von Dihydroxydicarbonsäuren und Diisocyanaten (Polyoxazindion-Prepolymere) ; und

— Polyadditionsprodukte von Diaminodicarbonsäuren und Diisocyanaten (Polychinazolindion-Prepolymere).

Die bevorzugt eingesetzten Tetracarbonsäuredianhydride sind das Anhydrid der Pyromellithsäure und der Benzophenontetracarbonsäure. Verwendung findet beispielsweise aber auch das Trimellithsäureanhydrid folgender Struktur (3) :

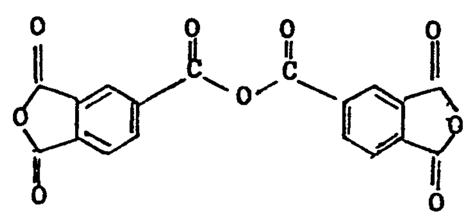

(3)

bzw. das Diesterdianhydrid der Struktur (4) :

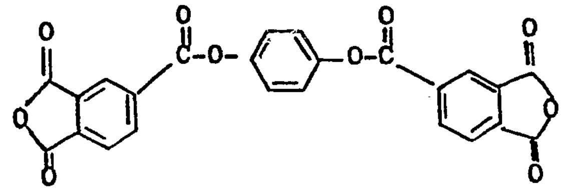

(4)

Bei den Diaminoverbindungen ist der 4.4'-Diaminodiphenyläter bevorzugt, bei den o-Aminoamiden das 4.4'-Diaminodiphenyl-3.3'-dicarbonsäureamid. Als Dihydroxydicarbonsäure wird bevorzugt die 4.4'-Dihydroxydiphenylmethan-3.3'-dicarbonsäure (Methylen-disalicylsäure) eingesetzt, als Diaminodicarbonsäure die 4.4'-Diaminodiphenyl-3.3'-dicarbonsäure. Das bevorzugte Diisocyanat ist 4.4'-Diphenylmethandiisocyanat.

An die genannten carboxylgruppenhaltigen Prepolymeren werden olefinisch ungesättigte Monoepoxide addiert. Diese Epoxide weisen folgende Struktur (5) auf, wobei der ungesättigte Rest $R^2$ die vorstehend angegebene Bedeutung besitzt :

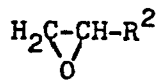

(5)

Bevorzugt werden die ungesättigten Epoxide Glycidylacrylat und -methacrylat.

Anhand der nachfolgenden Formeln (6) und (7) wird die Struktur der erfindungsgemäßen strahlungsreaktiven Vorstufen beispielhaft verdeutlicht :

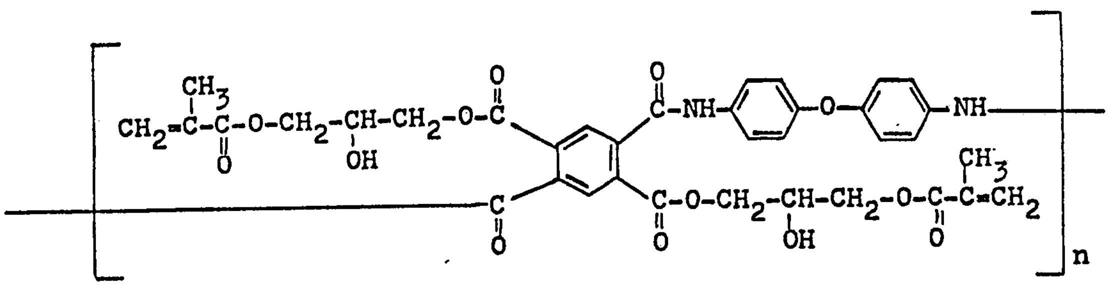

(6)

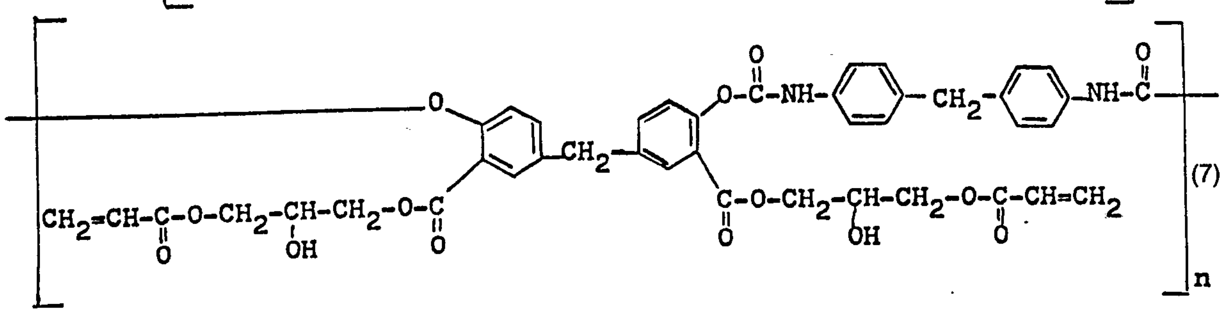

(7)

In Formel (6) ist dabei eine strahlungsreaktive Polyimid-Vorstufe dargestellt und zwar das Additionsprodukt von Glycidylmethacrylat an das Polyadditionsprodukt aus Pyromellithsäuredianhydrid und 4.4'-Diaminodiphenyläther. Formel (7) zeigt das Additionsprodukt von Glycidylacrylat an das Polyadditionsprodukt aus 3.3'-Dicarboxyl-4.4'-dihydroxydiphenylmethan und 4,4'-Diphenylmethandiisocyanat, d. h. eine strahlungsreaktive Polyoxazindion-Vorstufe, und zwar speziell eine Polybenzoxazindion-Vorstufe.

Die erfindungsgemäßen Vorstufen weisen als Grundbausteine bevorzugt aromatische Carbonsäuren auf und ergeben somit bei der thermischen Behandlung Polymere mit folgenden Struktureinheiten (8) bis (11) :

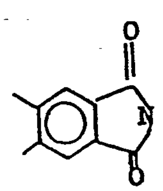

(8)

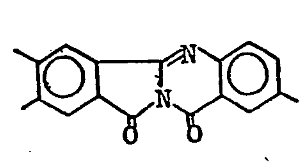

(9)

Polyimid

Polyisoindolochinazolindion

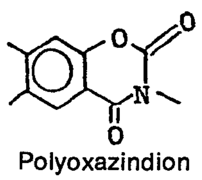 (10) 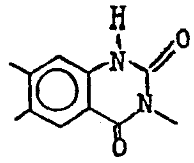 (11)

Polyoxazindion Polychinazolindion

Der Begriff « Polyimide » soll dabei auch Polyesterimide (12) und Polyamidimide (13) umfassen :

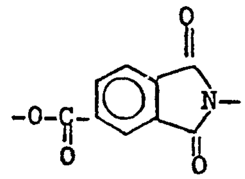 (12) 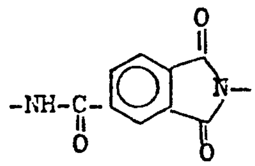 (13)

Die erfindungsgemäßen Polyimid-, Polyisoindolochinazolindion-, Polyoxazindion- und Polychinazolindion-Vorstufen werden vorteilhaft in der Weise hergestellt, daß ein aromatisches und/oder heterocyclisches Tetracarbonsäuredianhydrid mit einer Diaminoverbindung oder einer Diaminoverbindung mit wenigstens einer ortho-ständigen Amidogruppe bzw. eine aromatische und/oder heterocyclische Dihydroxydicarbonsäure oder eine entsprechende Diaminodicarbonsäure mit einem Diisocyanat zu einem carboxylgruppenhaltigen Reaktionsprodukt umgesetzt wird und daß das Reaktionsprodukt bei Raumtemperatur oder bei Temperaturen bis ca. 100 °C in einem organischen Lösungsmittel, gegebenenfalls in Gegenwart eines aminischen Katalysators, mit einem olefinisch ungesättigten Monoepoxid zur Reaktion gebracht wird.

Dieses Verfahren ist präparativ einfach durchzuführen, wobei im allgemeinen Temperaturen von ca. 50 bis 60 °C ausreichend sind. Da an der Reaktion keine Säurechloride beteiligt sind, sind keine aufwendigen Kühl- und Reinigungsoperationen erforderlich. Die Reaktionsprodukte fallen darüber hinaus in reinem Zustand an.

Die überraschende Tatsache, daß die Reaktion der ungesättigten Monoepoxide mit den carboxylgruppenhaltigen Prepolymeren bereits bei Temperaturen $< 100$ °C erfolgt, ist beim erfindungsgemäßen Verfahren von entscheidender Bedeutung. Bei Temperaturen $> 100$ °C ist nämlich bereits mit der Umwandlung der Vorstufen in unlösliche Cyclisierungsprodukte zu rechnen.

Vorteilhaft kann beim erfindungsgemäßen Verfahren das Tetracarbonsäuredianhydrid bei der Umsetzung mit der Diaminoverbindung, d. h. bei der Herstellung der sogenannten Prepolymeren, im Überschuß eingesetzt werden, wobei dann das erhaltene Reaktionsprodukt, eine Polyamidocarbonsäure, vor der Umsetzung mit dem olefinisch ungesättigten Monoepoxid mit Hydroxyäthylacrylat und/oder -methacrylat zur Reaktion gebracht wird. Auf diese Weise werden die endständigen Säureanhydridgruppen abgefangen und es werden Verbindungen mit klar definierter Struktur erhalten. Über das Abfangreagenz kann auch die Löslichkeit beeinflußt werden, insbesondere kann aber — aufgrund des ungesättigten Charakters dieser Komponente — eine erhöhte Empfindlichkeit der strahlungsreaktiven Vorstufe erreicht werden.

Außer zur Verwendung als Photoresist und zur Herstellung von Schutz- und Isolierschichten, wobei eine Strukturierung erfolgt, können die erfindungsgemäßen Vorstufen auch allgemein — in nicht strukturierter Form — zur Herstellung von Schutz- und Isolierüberzügen dienen. Besonders vorteilhaft können diese Vorstufen dabei zur Herstellung von Kunststoffüberzügen für die Lichtleitfasern von Lichtwellenleitern verwendet werden.

Anhand von Ausführungsbeispielen soll die Erfindung noch näher erläutert werden.

## Beispiel 1

Herstellung einer strahlungsreaktiven Polyimid-Vorstufe

Zu 65,4 Gewichtsteilen Pyromellithsäuredianhydrid (0,3 Mol) in 450 Volumenteilen Dimethylacetamid werden unter Rühren 45 Gewichtsteile 4.4'-Diaminodiphenyläther (0,23 Mol) gegeben und anschließend wird zwei Stunden lang bei Raumtemperatur gerührt. Dann werden dem Reaktionsgemisch zwei Gewichtsteile Methacrylsäure-2-hydroxyäthylester (0,016 Mol) zugesetzt, um die noch vorhandenen endständigen Anhydridgruppen zu binden. Nach 2 stündigem Rühren bei Raumtemperatur werden zur Reaktionslösung 150 Volumenteile Glycidylmethacrylat, 1,5 Gewichtsteile Benzyldimethylamin und 0,1 Gewichtsteile Hydrochinon gegeben. Anschließend wird die Lösung unter Rühren 23 Stunden auf eine Temperatur von 50 bis 60 °C erwärmt und dann wird sie unter kräftigem Rühren zu 4 000 Volumenteilen Äthanol getropft. Der dabei gebildete Niederschlag wird abgesaugt und im Vakuum bei Raumtemperatur

getrocknet. Das Reaktionsprodukt ist in wäßriger alkalischer Lösung nicht mehr löslich, löst sich aber in polaren organischen Lösungsmitteln. Im IR-Spektrum zeigt die Polyimid-Vorstufe eine Esterbande bei 5,8 µm.

### Beispiel 2

Herstellung einer strahlungsreaktiven Polyamidimid-Vorstufe

50 Gewichtsteile eines aus 2.6-Diaminopyridin und Trimellithsäureanhydrid hergestellten Polyamidimid-Prepolymeren werden in 200 Volumenteilen Dimethylacetamid gelöst und unter Rühren mit 0,05 Gewichtsteilen Benzyldimethylamin, 0,05 Gewichtsteilen Hydrochinon und 75 Volumenteilen Glycidylmethacrylat versetzt. Danach wird die Lösung 19 Stunden lang auf eine Temperatur von 50 bis 60 °C erwärmt und anschließend das Harz aus 3 000 Volumenteilen Äthanol in Form eines gelbbraunen Pulvers ausgefällt. Das IR-Spektrum (Film) zeigt eine Esterbande bei 1 720 $cm^{-1}$ (5,8 µm) ; die Absorptionsbanden der Methacrylatgruppe liegen bei 950 und 1 290 $cm^{-1}$.

### Beispiel 3

Herstellung einer strahlungsreaktiven Polychinazolindionimid-Vorstufe

Aus 22 Gewichtsteilen Pyromellithsäuredianhydrid, gelöst in 200 Volumenteilen Dimethylacetamid, und 27 Gewichtsteilen 3-(p-Aminophenyl)-7-amino-2.4-(1H, 3H)-chinazolindion, gelöst in 150 Volumenteilen Dimethylacetamid, wird nach einer 2stündigen Reaktionszeit bei Raumtemperatur unter Rühren ein Polychinazolindionimid-Prepolymeres erhalten.

Zur Lösung dieses Prepolymeren in Dimethylacetamid werden 2 Volumenteile Acrylsäure-2-hydroxyäthylester gegeben. Nach 1 stündigem Rühren wird die Reaktionslösung mit 50 Volumenteilen Glycidylacrylat, 0,5 Gewichtsteilen Benzyldimethylamin und 0,05 Gewichtsteilen Hydrochinon versetzt. Nach 20 stündigem Erwärmen auf eine Temperatur von ca. 60 °C wird die Lösung unter kräftigem Rühren in 3 000 Volumenteile Methanol eingetropft. Das sich dabei abscheidende Harz wird abgesaugt, mit Methanol gewaschen und im Vakuum bei Raumtemperatur getrocknet. Das Harz ist in wäßriger alkalischer Lösung unlöslich und zeigt im IR-Spektrum eine Esterbande bei 5,8 µm.

### Beispiel 4

Herstellung einer strahlungsreaktiven Polyisoindolochinazolindion-Vorstufe

11 Gewichtsteile 4.4'-Diaminodiphenyl-3.3'-dicarbonsäureamid werden in 120 Volumenteilen Dimethylacetamid aufgeschlämmt und unter Rühren mit 10 Gewichtsteilen Pyromellithsäuredianhydrid, gelöst in 100 Volumenteilen eines Dimethylacetamid/Dimethylformamid-Gemisches (Volumenverhältnis 1 : 1), versetzt. Nach 2 stündigem Rühren werden zur erhaltenen Lösung 25 Volumenteile Glycidylmethacrylat, 0,5 Gewichtsteile Benzyldimethylamin und 0,05 Gewichtsteile Hydrochinonmonoäthyläther gegeben. Nach 25 stündigem Rühren bei einer Temperatur von 60 °C wird aus der Lösung mit 3 000 Volumenteilen Propanol ein Harz ausgefällt und getrocknet. Dieses Harz ist in wäßrigen alkalischen Lösungen nicht mehr löslich und zeigt im IR-Spektrum eine Esterbande bei 5,8 µm.

### Beispiel 5

Herstellung einer strahlungsreaktiven Polybenzoxazindion-Vorstufe

Zu einer Lösung von 28,8 Gewichtsteilen Methylendisalicylsäure (0,1 Mol) und 0,1 Gewichtsteilen 1.4-Diazabicyclo [2.2.2] octan als Katalysator in 100 Volumenteilen N-Methylpyrrolidon werden bei Raumtemperatur unter Rühren 25 Gewichtsteile p.p'-Diphenylmethandiisocyanat (0,1 Mol), gelöst in 50 Volumenteilen N-Methylpyrrolidon, langsam zugetropft. Nach einer Reaktionszeit von 20 Stunden bei Raumtemperatur werden zu dieser Lösung unter Rühren 75 Volumenteile Glycidylacrylat und 0,1 Gewichtsteile Hydrochinon gegeben. Nach einer weiteren Reaktionszeit von 20 Stunden bei einer Temperatur von 50 bis 60 °C und 48 Stunden bei Raumtemperatur wird das Harz mit 2 000 Volumenteilen Toluol ausgefällt und im Vakuum getrocknet.

5 Gewichtsteile des getrockneten Harzes werden in 20 Volumenteilen eines Dimethylacetamid/Dioxan-Gemisches (Volumenverhältnis 1 : 1) gelöst, auf einer Aluminiumfolie zu einem Film geschleudert und 2 Minuten lang mit einer 500 W-Quecksilberhöchstdrucklampe belichtet. Die dabei erhaltene Lackschicht ist in einem Dimethylacetamid/Dioxan-Gemisch unlöslich.

### Beispiel 6

Herstellung einer strahlungsreaktiven Polychinazolindion-Vorstufe

1,4 Gewichtsteile 4.4'-Diphenylmethandiisocyanat werden bei ca. 100 °C in 110 Gewichtsteilen Polyphosphorsäure gelöst und dann wird auf ca. 140 °C erhitzt. Unter Stickstoff werden zur dabei erhaltenen Lösung 1,36 Gewichtsteile 4.4'-Diamino-3.3'-diphenyldicarbonsäure gegeben. Die Reaktionsmischung wird bei einer Temperatur von 150 bis 155 °C 5 Stunden lang kräftig gerührt, nach dem Abkühlen wird mit 1 000 Volumenteilen Wasser ausgefällt und das dabei erhaltene gelbbraune Produkt (2,7 Gewichtsteile) getrocknet. Das nicht strahlungsreaktive Prepolymere, eine Polyharnstoffsäure, zeigt im IR-Spektrum eine Absorption bei 1 670 $cm^{-1}$, die für die Harnstoffgruppierung typisch ist. Hingegen treten keine Chinazolindionbanden auf, die bei 1 730 $cm^{-1}$ liegen müßten, d. h. es hat noch keine partielle Cyclisierung stattgefunden.

2,7 Gewichtsteile der auf die beschriebene Weise erhaltenen Polyharnstoffsäure werden in 50 Volumenteilen N-Methylpyrrolidon gelöst und unter Rühren mit 0,5 Gewichtsteilen Benzyldimethylamin, 0,5 Gewichtsteilen Hydrochinon und 20 Volumenteilen Glycidylmethacrylat versetzt und 20 Stunden auf eine Temperatur von ca. 60 °C erwärmt. Die dabei erhaltene Lösung wird dann zu 500 Volumenteilen Propanol getropft und das abgeschiedene Harz getrocknet. Das resultierende gelbbraune Pulver ist in 1 %iger wäßrig-alkalischer Lösung nicht mehr löslich. Das IR-Spektrum zeigt Methacrylatabsorptionsbanden bei 950 und 1 290 $cm^{-1}$ und eine Esterbande bei 1 720 $cm^{-1}$.

**Ansprüche**

1. Oligomere und/oder polymere strahlungsreaktive Vorstufen von Polyimiden, Polyisoindolochinazolindionen, Polyoxazindionen und Polychinazolindionen, dadurch gekennzeichnet, daß sie aus Additionsprodukten von olefinisch ungesättigten Monoepoxiden an carboxylgruppenhaltige Polyadditionsprodukte aus aromatischen und/oder heterocyclischen Tetracarbonsäuredianhydriden und Diaminoverbindungen, welchletztere wenigstens eine ortho-ständige Amidogruppe enthalter können bzw. an carboxylgruppenhaltige Polyadditionsprodukte aus aromatischen und/oder heterocyclischen Dihydroxydicarbonsäuren oder entsprechenden Diaminodicarbonsäuren und Diisocyanaten bestehen.

2. Strahlungsreaktive Vorstufen nach Anspruch 1, dadurch gekennzeichnet, daß das ungesättigte Monoepoxid Glycidylacrylat oder -methacrylat ist.

3. Strahlungsreaktive Vorstufen nach Anspruch 1 oder 2, dadurch gekennzeichnet, daß das Tetracarbonsäuredianhydrid das Anhydrid der Pyromellithsäure oder Benzophenontetracarbonsäure ist.

4. Strahlungsreaktive Vorstufen nach einem der Ansprüche 1 bis 3, dadurch gekennzeichnet, daß die Diaminoverbindung 4.4'-Diaminodiphenyläther bzw. 4.4'-Diaminodiphenyl-3.3'-dicarbonsäureamid ist.

5. Strahlungsreaktive Vorstufen nach Anspruch 1 oder 2, dadurch gekennzeichnet, daß die Dihydroxydicarbonsäure 4.4'-Dihydroxydiphenylmethan-3.3'-dicarbonsäure ist.

6. Strahlungsreaktive Vorstufen nach Anspruch 1 oder 2, dadurch gekennzeichnet, daß die Diaminodicarbonsäure 4.4'-Diaminodiphenyl-3.3'-dicarbonsäure ist.

7. Strahlungsreaktive Vorstufen nach einem der Ansprüche 1, 2, 5 oder 6, dadurch gekennzeichnet, daß das Diisocyanat 4.4'-Diphenylmethandiisocyanat ist.

8. Verfahren zur Herstellung von strahlungsreaktiven Vorstufen nach einem oder mehreren der Ansprüche 1 bis 7, dadurch gekennzeichnet, daß ein aromatisches und/oder heterocyclisches Tetracarbonsäuredianhydrid mit einer Diaminoverbindung, welche wenigstens eine ortho-ständige Amidogruppe enthalten kann, bzw. eine aromatische und/oder heterocyclische Dihydroxydicarbonsäure oder eine entsprechende Diaminodicarbonsäure mit einem Diisocyanat zu einem carboxylgruppenhaltigen Reaktionsprodukt umgesetzt wird und daß das Reaktionsprodukt bei Raumtemperatur oder bei Temperaturen bis 100 °C in einem organischen Lösungsmittel, gegebenenfalls in Gegenwart eines aminischen Katalysators, mit einem olefinisch ungesättigten Monoepoxid zur Reaktion gebracht wird.

9. Verfahren nach Anspruch 8, dadurch gekennzeichnet, daß das Tetracarbonsäuredianhydrid bei der Umsetzung mit der Diaminoverbindung im Überschuß eingesetzt und das erhaltene Reaktionsprodukt vor der Umsetzung mit dem Monoepoxid mit Hydroxyäthylacrylat und/oder -methacrylat zur Reaktion gebracht wird.

10. Verwendung der strahlungsreaktiven Vorstufen nach einem oder mehreren der Ansprüche 1 bis 7 zur Herstellung von Kunststoffüberzügen für die Lichtleitfasern von Lichtwellenleitern.

**Claims**

1. Oligomeric and/or polymeric radiation-reactive precursors of polyimides, polyiso-indoloquinazolindiones, polyoxazindiones and polyquinazolindiones, characterised in that, they consist of addition products of olefinically-unsaturated mono-epoxides with polyaddition products containing carboxyl groups, formed from aromatic and/or heterocyclic tetracarboxylic acid dianhydrides and diaminocompounds, which latter may contain at least one amido-group in the ortho-position, or with polyaddition products containing carboxyl groups, formed from aromatic and/or heterocyclic dihydroxydicarboxylic acids, or the corresponding diaminodicarboxylic acids, and diisocyanates.

2. Radiation-reactive precursors as claimed in Claim 1, characterised in that the unsaturated

monoepoxide is glycidyl acrylate or methacrylate.

3. Radiation-reactive precursors as claimed in Claim 1 or Claim 2, characterised in that the tetracarboxylic acid dianhydride is pyromellitic acid anhydride or benzophenonetetracarboxylic acid anhydride.

4. Radiation-reactive precursors as claimed in one of Claims 1 to 3, characterised in that the diaminocompound is 4.4'-diaminodiphenylether or 4.4'-diaminodiphenyl-3.3'-dicarboxylic acid amide.

5. Radiation-reactive precursors as claimed in Claim 1 or Claim 2, characterised in that the dihydroxydicarboxylic acid is 4.4'-dihydroxydiphenylmethane-3.3'-dicarboxylic acid.

6. Radiation-reactive precursors as claimed in Claim 1 or Claim 2, characterised in that the diaminodicarboxylic acid is 4.4'-diaminodiphenyl-3.3'-dicarboxylic acid.

7. Radiation-reactive precursors as claimed in one of Claims 1, 2, 5 or 6, characterised in that the diisocyanate consists of 4.4'-diphenylmethane diisocyanate.

8. A process for the production of radiation-reactive precursors as claimed in one or more of Claims 1 to 7, characterised in that an aromatic and/or heterocyclic tetracarboxylic acid dianhydride is reacted with a diamino-compound which may contain at least one amido-group in the ortho-position, or an aromatic and/or heterocyclic dihydroxydicarboxylic acid, or the corresponding diaminodicarboxylic acid, is reacted with a diisocyanate to form a reaction product which contains carboxyl groups ; and that the reaction product is caused to react with an olefinicallyunsaturated mono-epoxide at room temperature or at temperatures of up to 100 °C in an organic solvent, if necessary in the presence of an amine catalyst.

9. A process as claimed in Claim 8, characterised in that an excess of tetracarboxylic acid dianhydride is used in the reaction with the diamino-compound and the reaction product produced is caused to react with hydroxyethyl acrylate and/or methacrylate prior to reaction with the mono-epoxide.

10. The use of the radiation-reactive precursors as claimed in one or more of Claims 1 to 7 for the production of synthetic coatings for the light-conducting fibres of light waveguides.

**Revendications**

1. Précurseurs réactifs au rayonnement, oligomères et/ou polymères de polyimides, de polyisoindoloquinazolinediones, de polyoxazinediones et de polyquinazolinediones, caractérisés en ce qu'ils sont constitués de produits d'addition de monoépoxydes à insaturation oléfinique sur des produits de polyaddition, contenant des groupes carboxyliques, de dianhydrides d'acides tétracarboxyliques aromatiques et/ou hétérocycliques et de composés diamino, ces derniers pouvant avoir au moins un groupe amido en position ortho, ou sur des produits de polyaddition, contenant des groupes carboxyliques, d'acides dihydroxydicarboxyliques aromatiques et/ou hétérocycliques ou d'acides diaminodicarboxyliques correspondants et de diisocyanates.

2. Précurseurs réactifs au rayonnement suivant la revendication 1, caractérisés en ce que le monoépoxyde insaturé est l'acrylate de glycidyle ou le méthacrylate de glycidyle.

3. Précurseurs réactifs au rayonnement suivant la revendication 1 ou 2, caractérisés en ce que le dianhydride d'acide tétracarboxylique est l'anhydride de l'acide pyromellitique ou de l'acide benzophénonetétracarboxylique.

4. Précurseurs réactifs au rayonnement suivant l'une des revendications 1 à 3, caractérisés en ce que le composé diamino est l'éther 4,4'-diaminodiphénylique ou l'amide de l'acide 4,4'-diaminodiphényl-3,3'-dicarboxylique.

5. Précurseurs réactifs au rayonnement suivant la revendication 1 ou 2, caractérisés en ce que l'acide dihydroxydicarboxylique est l'acide 4,4'-dihydrodiphénylméthane-3,3'-dicarboxylique.

6. Précurseurs réactifs au rayonnement suivant la revendication 1 ou 2, caractérisés en ce que l'acide diaminodicarboxylique est l'acide 4,4'-diaminodiphényl-3,3'-dicarboxylique.

7. Précurseurs réactifs au rayonnement suivant l'une des revendications 1, 2, 5 ou 6, caractérisés en ce que le diisocyanate est le 4,4'-diisocyanate de diphénylméthane.

8. Procédé de préparation de précurseurs réactifs au rayonnement suivant l'une ou plusieurs des revendications 1 à 7, caractérisé en ce qu'il consiste à faire réagir un dianhydride d'acide tétracarboxylique aromatique et/ou hétérocyclique sur un composé diamino, ce dernier pouvant avoir au moins un groupe amido en position ortho, ou un acide dihydroxydicarboxylique aromatique et/ou hétérocyclique ou un acide diamino dicarboxylique correspondant sur un diisocyanate pour obtenir un produit de réaction contenant des groupes carboxyliques et à mettre le produit de réaction à réagir à température ambiante ou à des températures allant jusqu'à 100 °C dans un solvant organique, le cas échéant en présence d'un catalyseur aminé, sur un monoépoxyde à insaturation oléfinique.

9. Procédé suivant la revendication 8, caractérisé en ce qu'il consiste à engager le dianhydride d'acide tétracarboxylique en excès lors de la réaction sur le composé diamino et à mettre le produit de réaction obtenu à réagir, avant la réaction sur le monoépoxyde, sur l'acrylate d'hydroxyéthyle et/ou sur le méthacrylate d'hydroxyéthyle.

10. Utilisation de précurseurs réactifs au rayonnement selon l'une ou plusieurs des revendications 1 à 7, à la fabrication de revêtement en matière plastique pour des fibres optiques de guides d'ondes lumineuses.